# EUROPEAN PATENT SPECIFICATION

(11) **EP 1 459 111 B1**
(45) Date of publication and mention of the grant of the patent: **06.06.2007**
(21) Application number: 02719802.7
(22) Date of filing: 12.02.2002
(51) Int. Cl.: H01S 5/14, G02B 5/122

(54) **EXTERNAL CAVITY WITH RETRO-REFLECTING DEVICE IN PARTICULAR FOR TUNABLE LASERS**
EXTERNER RESONATOR MIT RETRO-REFLEKTIERENDER VORRICHTUNG INSBESONDERE FÜR ABSTIMMBARE LASER
CAVITE EXTERNE AVEC DISPOSITIF RETRO-REFLECHISSANT NOTAMMENT POUR LES LASERS ACCORDABLES

(30) Priority: 14.12.2001 EP 01129781
(43) Date of publication of application: 22.09.2004
(73) Proprietor: Agilent Technologies, Inc., Santa Clara, CA 95051 (US)
(72) Inventor: STEFFENS, Wolf, 71083 Herrenberg (DE); KALLMANN, Ulrich, 72070 Tuebingen (DE); MUELLER, Emmerich, 71134 Aidlingen (DE)
(74) Representative: Barth, Daniel Mathias
(86) International application number: PCT/EP2002/001433
(87) International publication number: WO 2003/052883

(56) References cited:
- EP-A- 1 065 766
- EP-A- 1 099 972
- DE-A- 4 304 178
- US-A- 5 220 463
- US-A- 5 594 744

## Description

### BACKGROUND OF THE INVENTION

External cavity lasers tunable in wavelengths are well known in the art. A fundamental approach for achieving mode-hop free lasing is disclosed by Karen Liu and Michael G. Littman in "Novel Geometry for Single for Scanning of Tunable Laser", Optics Letters Vol. 6, No. 3, March 1981, which is generally referred to as the 'Littman Architecture'. In the external cavity of the laser, the laser beam is directed to a diffraction grating for wavelength filtering. A tuning mirror returns light back to the diffraction grating and provides one end of the external cavity. Under the right conditions, a rotation of the tuning elements can provide changes simultaneously in cavity lengths and diffraction angle matching the requirements for continuous single-mode scanning.

Since light emitting from the wavelength filter beam has to be retro-reflected by the tuning mirror, it is known to use dihedral elements instead of plain mirrors generally vulnerable to unwanted angle modifications. Such dihedral elements (disclosed e.g. in JP-A-5690642 by Kiyouto Giken K.K. or US-A-5, 594,744 by Photonetics) are generally made up of two plain mirrors having precisely an angle of 90°. Such retro-reflecting orthogonal dihedrals can be made up of two assembled plain mirrors or as an isosceles right-angled prism whose input face corresponding to the hypotenuse of the isosceles right-angled triangles is anti-reflection treated.

EP 1099972 discloses a variable optical delay line with an optical input and an optical output optically connected by a retro reflector that is mounted on a micro machine linear rack. The distance between the retro reflector and the input and output is variable by linearly moving the retro reflector.

US 5,220,463 discloses on optical delay line with first and second hollow front surface retro reflectors. An entrance is provided for introducing a light beam, so that the light beam is reflected between the first and the second retro reflector a plurality of times.

US 5,594,744 discloses a tunable single mode laser source with a self-aligned external cavity. The cavity comprises a retro reflecting dispersive device with a diffraction grating and an orthogonal reflecting dihedral for retro reflecting a dispersed beam back to the diffraction grating.

DE 43 04178 discloses an active folded resonator system with a laser active material, wherein a laser beam is reflected a plurality of times in order to generate pump light of a plurality of laser modes.

EP-A-1065766 discloses (fig. 3 and 5) a tunable laser with an external cavity comprising a diffraction grating and a retro-reflector consisting of two prisms with three reflecting faces, two of which arranged in parallel and one perpendicular to the parallel faces.

### SUMMARY OF THE INVENTION

It is an object of the present invention to provide an external cavity for a tunable laser comprising an improved retro-reflecting device and a wavelength filter. The invention is defined in the independent claims. Preferred embodiments are shown by the dependent claims.

An external cavity according to the present invention comprises a wavelength filter and a retro-reflector comprising three reflecting plates, two of which being arranged in parallel and one being arranged perpendicular to the parallel plates. The term 'plate' shall mean a device substantially providing a plane at least within a defined region. The inner sides of the plates (within the retro-reflector) are provided to be at least partially reflective and preferably fully reflective. At least one of the two parallel plates is preferably abutting to the perpendicular plate, thus providing an intersection or crossing line between one side of the this parallel plate and one side of the perpendicular plate.

In operation, a light beam received by the retro-reflector will be directed by a first one of the parallel plates to a second one of the parallel plates, the perpendicular plate, or a crossing point/line between the second parallel plate and the perpendicular plate. Dependent on the dimensions of the retro-reftector and the angle of the first plate with respect to the input beam, the beam will be redirected within the retro-reflector in total at least four times but eventually coupled out parallel to the incident beam but with opposite propagation direction. Thus, the retro-reflector will return a light beam parallel to the incident light beam with opposite direction. The reflection at the crossing point/line between the second parallel plate and the perpendicular plate counts as two reflections, since a beam generally has a certain diameter.

A laser tunable in wavelength comprises an external cavity having a diffraction element and the retro-reflector. The retro-reflector is arranged for retro-reflecting a beam wavelength filtered by the diffraction element back to the diffraction element. The retro-reflector thus provides one end of the cavity. The external cavity arrangement thus substantially corresponds with the aforementioned Littman Architecture.

For such external cavity applications, the invention allows providing a compact design. The cavity length can be expanded virtually without limitations and without requiring additional components, simply by expanding the length of the parallel plates (in the direction parallel to the normal vector of the perpendicular plate). Thus, signal purity of laser lines can be improved with increasing cavity length.

In more general terms and not limited to external laser applications, the retro-reflector allows to modify or vary optical properties (e.g. of the cavity) without requiring additional optical components. In particular, the optical path length provides a significant property (e.g. of the cavity) and can be modified by the retro-reflector. A first option for modifying the optical path length is, as stated above, by varying the length of the parallel plates in order to increase the number of reflections within the retro-reflector. A second option for modifying the optical path length can be applied when embodying the retro-reflector as a solid device with the reflecting plates being provided by the inner surface of the outside walls. Varying the refractive index of the retro-reflector material thus allows modifying the optical path length.

In a preferred embodiment, the refractive index of the retro-reflector material can be varied making use of an electro-optical effect of the material, e.g. by applying an electrical field preferably between the parallel plates. However, other effects for varying the refractive index such as mechanical effects (e.g. by applying mechanical stress) can be applied accordingly.

A further advantage of the retro-reflector is that the polarization extinction ratio is increased with each total internal reflection (TIR), because TIR reflects light with a preferential polarization state with higher efficiency. This effect can be increased e.g. by applying an appropriate coating to the surfaces where TIR occurs ore by selecting a material having an appropriate refractive index.

The length of the parallel plates (in the direction parallel to the normal vector of the perpendicular plate) and also the depth of the retro-reflector provides a design degree of freedom for controlling the path length within the retro-reflector.

The two parallel plates can be provided having the same length. In a preferred embodiment, however, the length of one of the parallel plates is smaller in order to provide a wider beam opening for receiving the incident beam and/or emitting retroreflected beam.

The retro-reflector can be provided e.g. by three assembled plain mirrors or as solid device such as an etalon or a slab waveguide. For a solid device the beam opening may be anti-reflection treated and/or also may be slightly slanted or tilted with respect to the beam direction in order to minimize reflection in a beam propagation direction.

In a preferred application, the effective optical path length of the retro-reflector is adjusted in accordance with a wavelength-filtering in order to provide mode-hop free tuning of a laser beam. Further details about such effective optical path length adjustment are described in detail in the co-pending European Patent application No. 01121408.7 of the same applicant.

In another preferred embodiment of the invention, the retro-reflector further comprises a beam splitter arranged in the path of the light beam travelling in the retro-reflector. The beam splitter is preferably arranged with respect to the incident beam that one partial beam transmitted through the beam splitter and another partial beam reflected by the beam splitter travel the same path (but with opposite directions) within the retro-reflector and eventually meet at substantially the same position where the incident beam 'hit' the beam splitter. For that purpose, the beam splitter is preferably arranged substantially in parallel to the parallel plates, or, in other words, the normal to the beam splitter area is preferably parallel to the perpendicular plate.

In operation, the incident light beam received by the retro-reflector will be split by the beam splitter into one partial beam transmitted through the beam splitter and one other partial beam reflected by the beam splitter. While the transmitted partial beam will be directed to the first one of the parallel plates, the transmitted partial beam will be directed to the second one of the parallel plates. Dependent on the dimensions of the retro-reflector, each partial beam will be further redirected within the retro-reflector at least two other times before reaching again the beam splitter. In case the partial beams meet the beam splitter at substantially the same position as the incident beam, the partial beams will interfere with each other.

In a preferred embodiment, the beam splitter is selected having a splitting ratio different from 50:50; i.e. the portion reflected is different from the portion transmitted. In that case, the partial beams meeting at the beam splitter will interfere to a first and a second output beam. The first output beam travels substantially in the same path as the incident beam but with opposite propagation direction. The second output beam travels perpendicular to the first output beam. The second output beam is preferably further redirected by the first one of the parallel plates to leave the retro-reflector parallel to the first output beam.

In another preferred embodiment, the beam splitter is selected having a splitting ratio of substantially 50:50, i.e. the portion reflected and transmitted are substantially equal. In that case, the partial beams meeting at the beam splitter will constructively interfere to the first, while the second output beam is substantially canceled from destructive interference. Deviations from the splitting ratio of 50:50 will lead to the aforedescribed second output beam, whereby - dependent on the application - second output beams resulting from only small deviations might be neglected.

In case of an application of the retro-reflector (with the incorporated beam splitter) in the external cavity of a laser tunable in wavelength, the retro-reflector is arranged to receive its incident beam from a wavelength filter (preferably a diffraction element such as a grating). While the first output beam is retro-reflected back to the wavelength filter in the same path as the beam incident to the retro-reflector, the second output beam can be applied for coupling out a beam from the cavity. Such out-coupled beam might additionally be wavelength-filtered, preferably by also directing the second output beam to the wavelength filter.

The retro-reflector with the incorporated beam splitter is preferably made of glass as a solid device. However, three assembled plain mirrors and a beam splitter adjusted in an appropriate way also may provide the retro-reflecting device. The solid version may make use of total internal reflection. In the version wherein the reflector is assembled by mirrors and beam splitters, the mirror plates are preferably treated to have high reflectivity.

It goes without saying that all aforementioned variations or modifications of the retro-reflector (e.g. for optical path length control/variation) apply accordingly to the retro-reflector with or without the beam splitter.

The invention can be partly or entirely supported by one or more suitable software programs, which can be stored on or otherwise provided by any kind of data carrier, and which might be executed in or by any suitable data processing unit. Such software programs can be applied e.g. a control system preferably for controlling and/or varying the refractive index of the retro-reflector. This can be used e.g. to control the cavity length of the resonator in order to allow a compensation of mode hops during a wavelength sweep.

### BRIEF DESCRIPTION OF THE DRAWINGS

Other objects and many of the attendant advantages of the present invention will be readily appreciated and become better understood by reference to the following detailed description when considering in connection with the accompanied drawings. Features that are substantially or functionally equal or similar will be referred to with the same reference sign(s).
- Fig. 1: illustrates in principle the Littman Geometry that is preferably applied in conjunction with the present invention.
- Figs. 2-5: illustrate embodiments and applications of the retro-reflector according to the present invention.

### DETAILED DESCRIPTION OF THE INVENTION

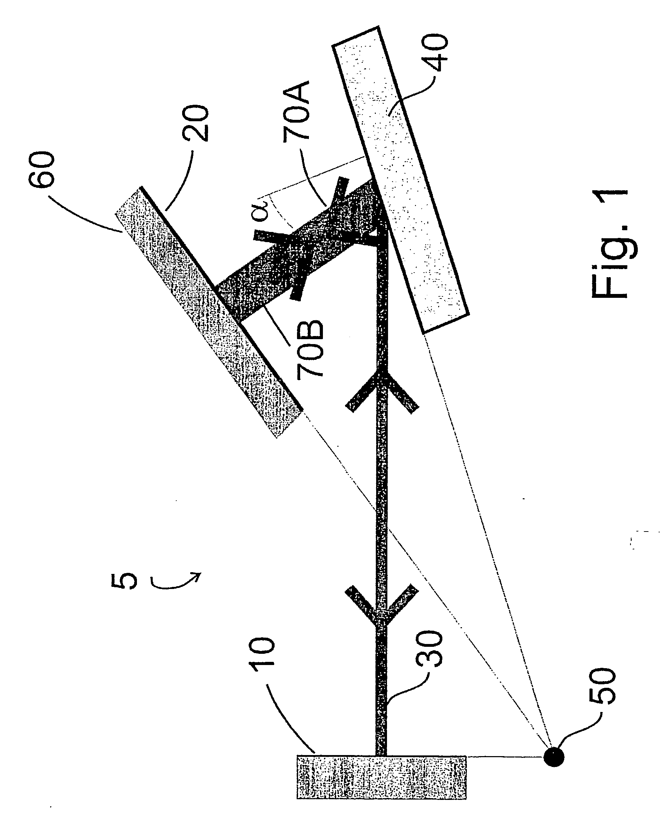

In Figure 1, a cavity 5 is provided between a first facet 10 and a second facet 20. An optical beam 30 travels in the cavity 5 between the first and second facets 10 and 20. A diffraction grating 40 is provided for wavelengths filtering the optical beam 30. An angle α (to the normal of the plane of the diffraction grating 40) determines the selected wavelength. A beam 70A from the grating 40 is retroreflected as a beam 7B back towards the grating 40. In the ideal Littman Geometry, the first and second facets 10 and 20 as well as the plane of the diffraction grating 40 are arranged with respect to a pivot point 50. Details about the Littman Geometry are readily apparent from the aforementioned document.

An optically active medium for generating and maintaining the beam 30 might be situated within the cavity 5 or couple into the cavity 5 e.g. through the first facet 10 (being partly transmittive).

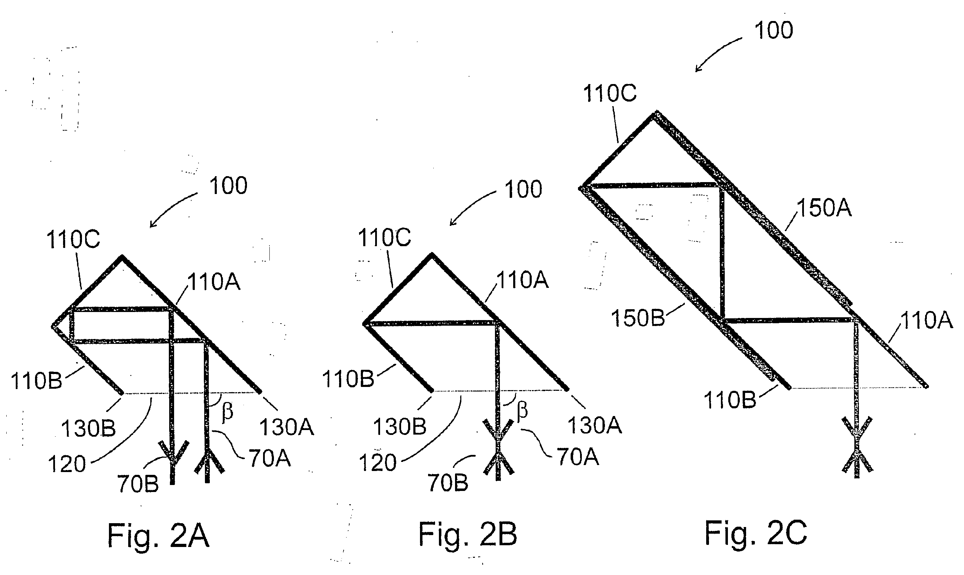

Instead of a plain mirror 60 providing the second facet 20 as indicated in Figure 1, the invention employs a retro-reflector 100 as illustrated in principle with respect to Figures 2A-2C. The retro-reflector 100 is comprised of three plates 110A, 110B and 110C. While the plates 110A and 110B are arranged parallel to each other, the third plate 110 C is arranged perpendicular to the two parallel plates 110A and 110 B and abutting to the sides of the parallel plates 110A and 110B.

In the embodiments of Figures 2A-2C, the parallel plates 110A and 110B are provided with different length of the plates, here with plate 110B being smaller than the plate 110A. The difference in length between the two parallel plates 110A and 110B allows designing the length of an opening 120 as the plane between outside sides 130A and 130B of the parallel plates 110A and 110B (on opposite sides as the sides abutting to the perpendicular plate 110C).

In operation, the incident beam 70A (e.g. originating from the grating 40 in Fig. 1) is reflected at the first parallel plate 110A to the second parallel plate 110B, and therefrom to the perpendicular plate 110C. The perpendicular plate 110C reflects the beam back towards the first parallel plate 110A, which eventually returns the beam 70B out of the retro-reflector 100 (e.g. back towards the grating 40). Due to the 90°-orientations of the three plates 110A-110C with respect to each other, the two beams 70A and 70B will always be parallel to each other but with opposite propagation directions. In other words, the incident beam 70A will provide the same entry angle β (with respect to the plane of the opening 120) than the output beam 70B.

Figure 2B illustrates a special case when the beam first reflected at the first parallel plate 110A directly hits a corner 110BC between the plates 110B and 110C. In that case, the beam will be retro-reflected in itself, so that the light beam 70B emerging from the retro-reflector 100 will be precisely at the same position as the incident beam 70A. However, due to the geometry of the retro-reflector 100, the path length of the beam travelling within the retro-reflector 100 (i.e. the path length between the beam 70A after passing the opening 120 and the beam 70B before passing the opening 120) is precisely the same for any beam entering the retro-reflector 100 at the same angle irrespective of the entry position (at the first parallel plate 110A). That means that the optical path length within the retro-reflector 100 is exactly the same for the beam propagation in the Figure 2A as well as in 2B. However, varying the entry angle β will also modify the path length within the retro-reflector 100.

Figure 2C illustrates the optical path in case that the retro-reflector 100 has a more elongated shape. While in Figures 2A and 2B the beam 70A is reflected only once at the first parallel plate 110A before returning as beam 70B, the beam 70A in Figure 2 C is reflected twice at the first parallel plate 110A before returning as beam 70B. That means that while there are four reflections in total within the retro-reflector 100 in the embodiments of Figures 2A and 2B, there will be in total eight reflections within the retro-reflector 100 in the embodiment of Figure 2C. It becomes readily apparent that increasing the lengths of the parallel plates 110A and 110B thus allows increasing the path length within the retro-reflector 100 and thus e.g. of the external cavity 5.

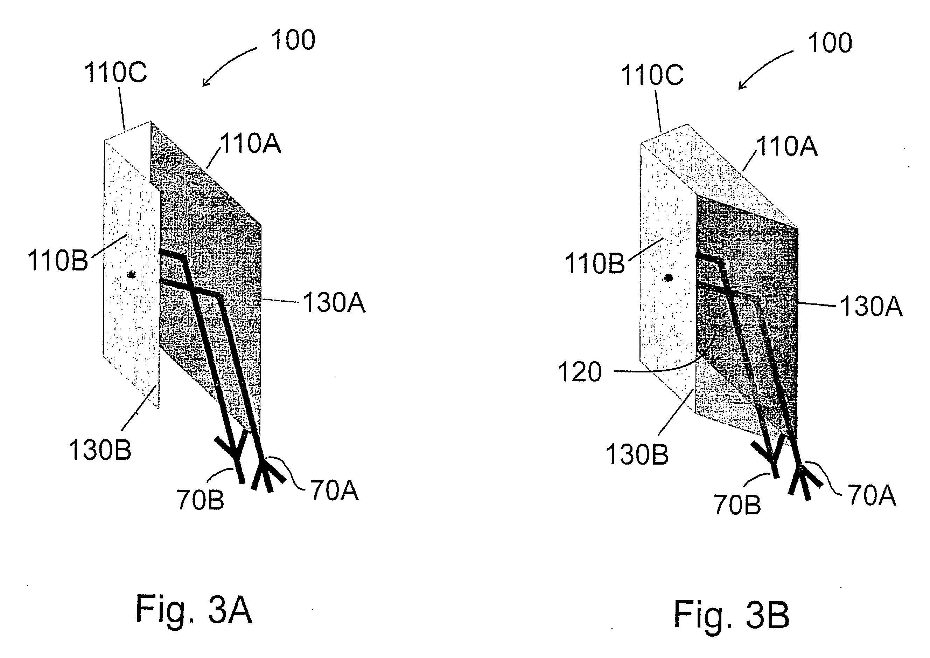

Figures 3A and 3B illustrate in 3-dimensional representation the retro-reflector 100 and the course of the beams 70A and 70B in accordance with the example as shown in Figure 2A. While the embodiment of Figure 3A is provided in an open form with three individual plates 110A-110C, Figure 3B shows another embodiment of the retro-reflector 100 in a closed solid version.

The tree individual plates of the open form (Figure 3A) generally need to be treated to have high reflectivity, whereas the solid version (Figure 3B) makes use of total internal reflection. The solid reflector may be manufactured by cutting and/or polishing a slab under an angle of about 45 degrees. This surface 120 is preferably anti-reflection treated and also may be slanted slightly with respect to the beam direction in order to minimize reflections in a beam propagating direction. An advantage of the open form of Figure 3A is that light propagating within the reflector does not suffer from any dispersion.

Returning to Figure 2C illustrates a preferred embodiment for modifying the optical path length within the retro-reflector 100. For that purpose, the retro-reflector 100 shall be embodied as a solid device as depicted in Figure 3B. Each of the parallel plates 110A and 110B is provided with electrodes 150A and 150B. Applying an electrical field between the electrodes 150A and 150B will change the refractive index of the retro-reflector material. Dependent on the application, either a static field for setting a defined effective refractive index of the retro-reflector 100 or a dynamic field for dynamically varying the effective refractive index of the retro-reflector 100 can be applied. Modifying the effective index of the retro-reflector 100 and thus modifying the effective optical path length of the retro-reflector 100 (and accordingly e.g. of the external cavity 5) is in particular advantageous for adjusting the effective optical path length of in a cavity (such as the cavity 5 in Fig. 1 in order to provide a mode-hop free tuning in wavelength.

In a preferred embodiment, the effective optical path lengths required for mode-hop free tuning will be determined for plurality of different wavelengths. A voltage value to be applied between the electrodes 150A and 150B for deriving the required effective optical path length will be determined for each of the plurality of different wavelengths and memorized e.g. in a table for calibration. In operation when tuning the external cavity laser between different wavelengths, the memorized voltage value will be set for each respective wavelength, thus allowing mode-hop free lasing. Alternatively, a control signal may be extracted form the optical properties of the light emitted by the laser during a wavelength sweep and used to compensate the cavity length within a closed feed back loop.

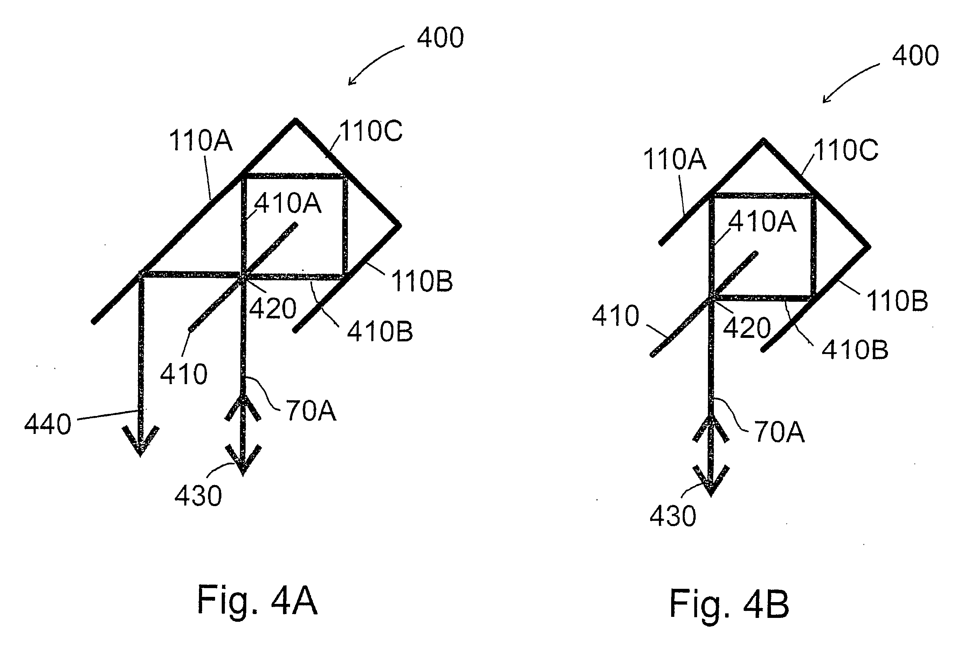

Figs. 4A and 4B show a different embodiment of the invention, wherein the retro-reflector 400 further incorporates a beam splitter 410. The beam splitter 410 is arranged with respect to the incident beam 70A that one partial beam 410A transmitted through the beam splitter 410 and another partial beam 410B reflected by the beam splitter 410 travel the same path (but with opposite directions) within the retro-reflector 400 and eventually meet at the same position 420 where the incident beam 70A hit the beam splitter 410. The beam splitter 410 is therefore arranged substantially in parallel to the parallel plates 110A and 110B.

In operation, the incident light beam 70A received by the retro-reflector 400 is split up by the beam splitter 410 into the partial beam 410A transmitted through the beam splitter 410 and the partial beam 410B reflected by the beam splitter 410. The transmitted partial beam 410A is reflected by the first parallel plate 110A, the perpendicular plate 110C, and the second parallel plate 110B and eventually reaches again the position 420. Accordingly, the transmitted partial beam 410B is reflected by the second parallel plate 110B, the perpendicular plate 110C, and the first parallel plate 110A and eventually also reaches again the position 420. Since both partial beams 410A and 410B have traveled substantially the same path and meet at the same position 420, the partial beams 410A and 410B will interfere with each other.

In the example of Fig. 4A, the beam splitter 410 has a splitting ratio different from 50:50, in this example e.g. of 30:70, so that 30% of the incident beam 70A is reflected and 70% is transmitted. In that case, the partial beams 410A and 410B will interfere to a first output beam 430 and a second output beam 440. The first output beam 430 travels substantially in the same path as the incident beam 70A but with opposite propagation direction. The second output beam 440 first travels perpendicular to the first output beam 430, but is then redirected by the first parallel plate 110A to leave the retro-reflector parallel to the first output beam 430.

In the example of Fig. 4B, the beam splitter 410 has a splitting ratio of 50:50, so that 50% of the incident beam 70A is reflected and 50% is transmitted. In that case, the partial beams 410A and 410B will constructively interfere to the first output beam 430, while the second output beam 440 is canceled from destructive interference.

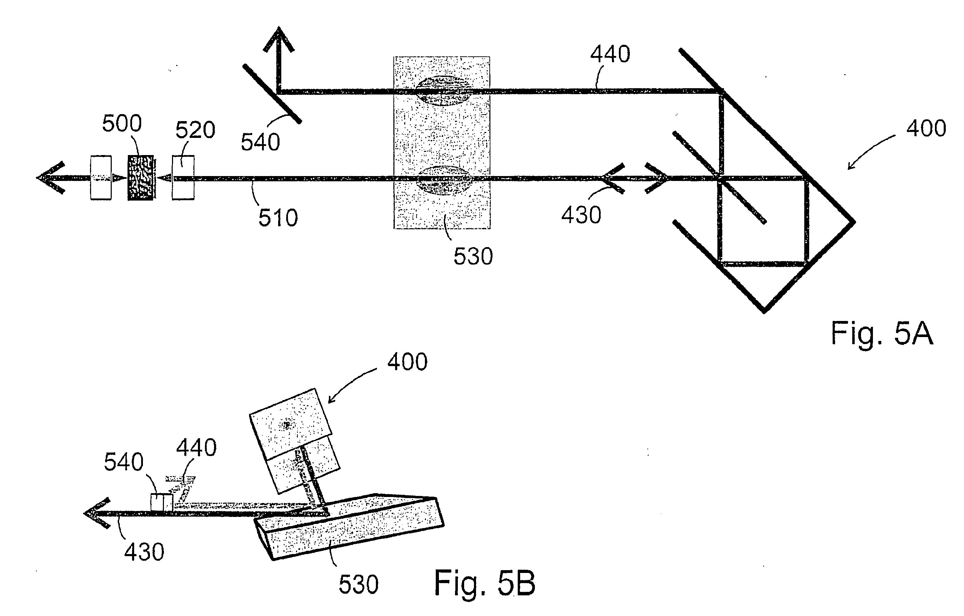

Figs. 5 depict in principle an application of the retro-reflector 400 in the external cavity 5 of a laser 500 tunable in wavelength. While Fig. 5A illustrates the optical path, Fig. 5B shows the 3.dimensional arrangement thereof. A light beam 510 from the laser chip 500 collimated by a collimating arrangement 520 (preferably a lens) is wavelength filtered by a diffraction element 530 (preferably a grating) and directed to the retro-reflector 400. In this example, the retro-reflector 400 of Fig. 4A is selected. The retro-reflector 400 retro-reflects a partial beam as the first output beam 430 back towards the diffraction element 530, thus providing a resonant cavity 5. The second output beam 440 is also directed towards the diffraction element 530, however in parallel to the first output beam 430 and spatially separated therefrom.

The second output beam 440 twice wavelength-filtered by the diffraction element 530 can be appropriately redirected as required, e.g. by a mirror 540 in the example of Figs. 5, and coupled out.

## Claims

1. An external cavity (5) adapted to be applied for a laser tunable in wavelength, comprising:
a wavelength filter (40; 530), and
a retro-reflector (100; 400) arranged for retro-reflecting at least a portion of a beam (70A) wavelength filtered by the wavelength filter (40; 530) back (70B) to the wavelength filter (40; 530),
wherein
the retro-reflector (100; 400) comprises three reflecting plates (110), two (110A, 110B) of which being arranged in parallel and one (110C) being arranged perpendicular to the parallel plates (110A, 110B), so that the retro-reflected beam (70B; 430, 440) is parallel to the incident beam (70A) but with opposite propagation direction,
**characterized in that**
wherein the retro-reflector (100; 400) is provided for adjusting the effective optical path length within the retro-reflector (100; 400) in accordance with a wavelength-filtering in order to provide mode-hop free tuning of the beam.

2. The external cavity (5) of claim 1, wherein the inner sides of the plates (110) within the retro-reflector are provided to be at least partially reflective and preferably fully reflective.

3. The external cavity (5) of claim 1 or 2, wherein at least one of the two parallel plates (110A, 110B) is abutting to the perpendicular plate (110C), thus providing an intersection or crossing line between one side of the this parallel plate and one side of the perpendicular plate.

4. The external cavity (5) according to claim 1 or any one of the above claims, wherein the length of one of the parallel plates (110A, 110B) is smaller in order to provide a wider beam opening (120) for receiving the incident beam (70A) and/or emitting the retro-reflected beam (70B; 430, 440).

5. The external cavity (5) according to claim 1 or any one of the above claims, wherein the three reflecting plates (110) are provided by three assembled plain mirrors or by a solid device, preferably an etalon or a slab waveguide.

6. The external cavity (5) according to claim 1 or any one of the above claims, wherein the effective optical path length within the retro-reflector (100) is variable by varying the length of the parallel plates and/or length of the perpendicular plate in order to increase the number of reflections within the retro-reflector.

7. The external cavity (5) according to claim 1 or any one of the above claims, wherein the effective optical path within the retro-reflector is variable by varying the refractive index of the retro-reflector material.

8. The external cavity (5) according to claim 7, comprising a unit (150) for applying an electro-optical effect of the retro-reflector material, preferably for applying an electrical field preferably between the parallel plates.

9. The external cavity (5) according to claim 1 or any one of the above claims, further comprising a beam splitter (410) arranged in the path of the light beam travelling in the retro-reflector (400).

10. The external cavity (5) of claim 9, wherein the beam splitter (410) is arranged with respect to the incident beam (70A) that a partial beam (410A) transmitted through the beam splitter (410) and a partial beam (410B) reflected by the beam splitter (410) travel the same path, but with opposite directions, within the retro-reflector and meet at substantially the same position (420) where the incident beam (70A) hit the beam splitter (410).

11. The external cavity (5) of claim 9 or 10, wherein the beam splitter (410) is arranged substantially in parallel to the parallel plates (110A and 110B), or the normal to the beam splitter (410) area is parallel to the perpendicular plate (110C).

12. The external cavity (5) of claim 9 or any one of the claims 10-11, wherein the beam splitter (410) provides a splitting ratio so that the portion reflected is different from the portion transmitted, the beam splitter (410) being arranged that the partial beams meeting at the beam splitter (410) interfere to a first output beam (430) and a second output beam (440).

13. The external cavity (5) of claim 12, wherein the first output beam (430) travels substantially in the same path as the incident beam (70A) but with opposite propagation direction, and the second output beam (440) travels perpendicular to the first output beam.

14. The external cavity (5) of claim 13, wherein the second output beam (440) is further redirected to leave the retro-reflector parallel to the first output beam.

15. The external cavity (5) of claim 9 or any one of the claims 10-11, wherein the beam splitter (410) provides a splitting ratio so that the portion reflected is substantially the same as the portion transmitted, the beam splitter (410) being arranged that the partial beams meeting at the beam splitter (410) interfere to a first output beam (430) traveling substantially in the same path as the incident beam (70A) but with opposite propagation direction, while a second output beam (440) perpendicular to the first output beam is substantially canceled by destructive interference.

16. The external cavity (5) of claim 1, further comprising a control unit for modifying the effective optical path length of the retro-reflector (100; 400) for providing mode-hop free tuning of a laser beam in the cavity (5).

17. The external cavity (5) of claim 12, wherein the first output beam (430) is retro-reflected back to the wavelength filter (530) and the second output beam (440) is coupled out of the cavity (5).

18. The external cavity (5) of claim 17, wherein the second output beam (440) is further wavelength-filtered by the wavelength filter (530).

19. The external cavity (5) of any one of the claims 17-18, wherein the wavelength filter (530) comprises a diffraction element.

20. A laser source tunable in wavelength, comprising:
a laser medium (500) emitting a laser beam (30), and
an external cavity (5) according to any one of the above claims, adapted for tuning the laser beam (30) in wavelength.

21. A method for wavelength tuning a laser beam (30) in an external cavity (5) having a retro-reflector (100) comprising three reflecting plates (110), two (110A, 110B) of which being arranged in parallel and one (110C) being arranged perpendicular to the parallel plates (110A, 110B), so that the retro-reflected beam (70B; 430, 440) is parallel to the incident beam (70A) but with opposite propagation direction, , comprising the steps of:
(a) varying a wavelength-filtering of the laser beam (30),
**characterized by**
(b) adjusting the effective optical path length within the retro-reflector (100) in accordance with the wavelength-filtering of step (a) in order to provide mode-hop free tuning of the laser beam (30),

22. The method of claim 21, wherein step (b) comprises at least one of the steps of:
varying the length of the parallel plates and/or length of the perpendicular plate of the retro-reflector (100) in order to increase the number of reflections within the retro-reflector, and/or
varying the refractive index of the retro-reflector material.

## Patentansprüche

1. Externer Resonator (5), der zur Verwendung für einen in der Wellenlänge abstimmbaren Laser geeignet ist und Folgendes aufweist:
ein Wellenlängenfilter (40;530), und
einen Retro-Reflektor (100;400), der so angeordnet ist, dass mindestens ein Teil eines durch das Wellenlängenfilter (40;530) in der Wellenlänge gefilterten Strahls (70A) zurück (70B) zum Wellenlängenfilter (40;530) reflektiert wird,
wobei
der Retro-Reflektor (100;400) drei reflektierende Platten (110) aufweist, von denen zwei (110A, 110B) parallel angeordnet sind und eine (110C) senkrecht zu den parallelen Platten (110A, 110B) angeordnet ist, so dass der retro-reflektierte Strahl (70B, 430,440) parallel zu dem einfallenden Strahl (70A), jedoch in entgegengesetzter Ausbreitungsrichtung verläuft,
**dadurch gekennzeichnet, dass**
der Retro-Reflektor (100;400) so gestaltet ist, dass die effektive optische Weglänge innerhalb des Retro-Reflektors (100;400) in Übereinstimmung mit einem Wellenlängenfiltervorgang angepasst wird, um ein modensprungfreies Abstimmen des Strahls zu ermöglichen.

2. Externer Resonator (5) nach Anspruch 1, wobei die inneren Seiten der Platten (110) innerhalb des Retro-Reflektors so gestaltet sind, dass sie zumindest teilweise reflektierend und vorzugsweise voll reflektierend sind.

3. Externer Resonator (5) nach Anspruch 1 oder 2, wobei mindestens eine der beiden parallelen Platten (110A, 110B) an die senkrechte Platte (110C) stößt und so eine Schnitt- oder Kreuzungslinie zwischen einer Seite dieser parallelen Platte und einer Seite der senkrechten Platte bildet.

4. Externer Resonator (5) nach Anspruch 1 oder einem der oben genannten Ansprüche, wobei die Länge einer der parallelen Platten (110A, 110B) kleiner ist, um eine größere Strahlöffnung (120) zu bilden, um den einfallenden Strahl (70A) aufzunehmen und/oder den retro-reflektierten Strahl (70B; 430,440) zu emittieren.

5. Externer Resonator (5) nach Anspruch 1 oder einem der vorhergehenden Ansprüche, wobei die drei reflektierenden Platten (110) durch drei zusammengesetzte, plane Spiegel oder durch eine feste Vorrichtung, vorzugsweise ein Etalon oder ein Flachwellenleiter, gebildet werden,.

6. Externer Resonator (5) nach Anspruch 1 oder einem der vorhergehenden Ansprüche, wobei die effektive optische Weglänge innerhalb des Retro-Reflektors (100) durch Variieren der Länge der parallelen Platten und/oder der Länge der senkrechten Platte variabel ist, um die Anzahl von Reflexionen innerhalb des Retro-Reflektors zu erhöhen.

7. Externer Resonator (5) nach Anspruch 1 oder einem der vorhergehenden Ansprüche, wobei der effektive optische Weg innerhalb des Retro-Reflektors durch Variieren des Brechungsindexes des retro-reflektierenden Materials variabel ist.

8. Externer Resonator (5) nach Anspruch 7, der eine Einheit (150) zum Anwenden eines elektro-optischen Effekts des retro-reflektierenden Materials aufweist, vorzugsweise zum Anlegen eines elektrischen Feldes, vorzugsweise zwischen den parallelen Platten.

9. Externer Resonator (5) nach Anspruch 1 oder einem der vorhergehenden Ansprüche, der des Weiteren einen Strahlteiler (410) aufweist, der in dem Weg des sich in dem Retro-Reflektor (400) bewegenden Lichtstrahls angeordnet ist.

10. Externer Resonator (5) nach Anspruch 9, wobei der Strahlteiler (410) in Bezug auf den einfallenden Strahl (70A) so angeordnet ist, dass ein Teilstrahl (410A), der durch den Strahlteiler (410) geleitet wird, und ein Teilstrahl (410B), der durch den Strahlteiler (410) reflektiert wird, innerhalb des Retro-Reflektors denselben Weg, diesen aber in entgegengesetzten Richtungen durchlaufen und sich im Wesentlichen an derselben Position (420) treffen, an der der einfallende Strahl (70A) auf den Strahlteiler (410) getroffen ist.

11. Externer Resonator (5) nach Anspruch 9 oder 10, wobei der Strahlteiler (410) im Wesentlichen parallel zu den parallelen Platten (110A oder 110B) angeordnet oder die Normale zu der Strahlteiler(410)-Ebene parallel zu der senkrechten Platte (110C) ist.

12. Externer Resonator (5) nach Anspruch 9 oder einem der Ansprüche 10 bis 11, wobei der Strahlteiler (410) ein Teilungsverhältnis dergestalt bereitstellt, dass sich der reflektierte Anteil von dem weitergeleiteten Anteil unterscheidet, wobei der Strahlteiler (410) so angeordnet ist, dass die Teilstrahlen, welche sich an dem Strahlteiler (410) treffen, einen ersten Ausgangsstrahl (430) und einen zweiten Ausgangsstrahl (440) überlagern.

13. Externer Resonator (5) nach Anspruch 12, wobei der erste Ausgangsstrahl (430) im Wesentlichen auf demselben Weg wie der einfallende Strahl (70A), aber in entgegengesetzter Ausbreitungsrichtung und der zweite Ausgabestrahl (440) senkrecht zu dem ersten Ausgabestrahl läuft.

14. Externer Resonator (5) nach Anspruch 13, wobei der zweite Ausgangsstrahl (440) zudem so umgelenkt wird, dass er den Retro-Reflektor parallel zu dem ersten Ausgabestrahl verlässt.

15. Externer Resonator (5) nach Anspruch 9 oder einem der Ansprüche 10 bis 11, wobei der Strahlteiler (410) ein Teilungsverhältnis dergestalt bereitstellt, dass der reflektierte Anteil im Wesentlichen gleich dem übertragenen Anteil ist, wobei der Strahlteiler (410) so angeordnet ist, dass die Teilstrahlen, welche sich an dem Strahlteiler (410) treffen, einen ersten Ausgangsstrahl (430) überlagern, welcher im Wesentlichen im selben Weg wie der einfallende Strahl (70A), aber mit entgegengesetzter Ausbreitungsrichtung läuft, während ein zweiter Ausgangsstrahl (440) senkrecht zu dem ersten Ausgabestrahl im Wesentlichen durch destruktive Interferenz ausgelöscht wird.

16. Externer Resonator (5) nach Anspruch 1, der des Weiteren eine Steuereinheit zum Verändern der effektiven optischen Weglänge des Retro-Reflektors (100;400) aufweist, um modensprungfreies Abstimmen eines Laserstrahls in dem Resonator (5) zu ermöglichen.

17. Externer Resonator (5) nach Anspruch 12, wobei der erste Ausgangsstrahl (430) zurück zum Wellenlängenfilter (530) retro-reflektiert wird und der zweite Ausgabestrahl (440) aus dem Resonator (5) ausgekoppelt wird.

18. Externer Resonator (5) nach Anspruch 17, wobei der zweite Ausgangsstrahl (440) zusätzlich durch das Wellenlängenfilter (530) in der Wellenlänge gefiltert wird.

19. Externer Resonator (5) nach einem der Ansprüche 17 bis 18, wobei das Wellenlängenfilter (530) ein Diffraktionselement aufweist.

20. Wellenlängenabstimmbare Laserquelle, die Folgendes aufweist:
ein Lasermedium (500), welches einen Laserstrahl (30) emittiert, und
einen externen Resonator (5) nach einem der vorhergehenden Ansprüche, wobei der Resonator zum Wellenlängen-Abstimmen des Laserstrahls (30) geeignet ist.

21. Verfahren zum Wellenlängenabstimmen eines Laserstrahls (30) in einem externen Resonator (5) mit einem Retro-Reflektor(100), welcher drei reflektierende Platten (110) aufweist, von denen zwei (110A, 110B) parallel angeordnet sind und eine (110C) senkrecht zu den parallelen Platten (110A, 110B) angeordnet ist, so dass der retro-reflektierte Strahl (70B, 430, 440) parallel zu dem einfallenden Strahl (70A), aber in entgegengesetzter Ausbreitungsrichtung verläuft, wobei das Verfahren weiterhin folgende Schritte aufweisend:
a) Variieren eines Wellenlängenfilterns des Laserstrahls (30),
**gekennzeichnet durch**
b) Anpassen der effektiven optischen Weglänge innerhalb des Retro-Reflektors (100) in Übereinstimmung mit dem Wellenlängenfiltervorgang des Schritts (a), um ein modensprungfreies Abstimmen des Laserstrahls (30) zu ermöglichen.

22. Verfahren nach Anspruch 21, wobei Schritt b) mindestens einen der folgenden Schritte aufweist:
Variieren der Länge der parallelen Platten und/oder der Länge der senkrechten Platte des Retro-Reflektors (100), um die Anzahl von Reflexionen innerhalb des Retro-Reflektors zu erhöhen, und/oder
Variieren des Brechungsindexes des retro-reflektierenden Materials.

## Revendications

1. Cavité externe (5) adaptée pour être utilisée pour un laser accordable en longueur d'onde, comprenant :
un filtre en longueur d'onde (40, 530), et
un rétroréflecteur (100, 400) positionné pour rétroréfléchir au moins une partie d'un faisceau (70A) filtré en longueur d'onde par le filtre en longueur d'onde (40, 530) vers (70B) le filtre en longueur d'onde (40, 530),
dans laquelle
le rétroréflecteur (100, 400) comprend trois lames réfléchissantes (110), deux (110A, 110B) d'entre elles étant positionnées parallèlement et l'une (110C) étant positionnée perpendiculairement aux deux lames parallèles (110A, 110B), de telle sorte que le faisceau rétroréfléchi (70B, 430, 440) est parallèle au faisceau incident (70A) mais avec un sens inverse de propagation,
**caractérisée en ce que** le rétroréflecteur (100, 400) est prévu pour ajuster la longueur du trajet optique réel à l'intérieur du rétroréflecteur (100, 400) corrélativement d'un filtrage en longueur d'onde afin de permettre d'accorder le faisceau sans saut de mode.

2. Cavité externe (5) selon la revendication 1, dans laquelle les faces internes des lames (110) à l'intérieur du rétroréflecteur sont prévues pour être au moins partiellement réfléchissantes et de préférence totalement réfléchissantes.

3. Cavité externe (5) selon la revendication 1 ou 2, dans laquelle au moins une des deux lames parallèles (110A, 110B) est attenante à la lame perpendiculaire (110C), permettant ainsi une intersection ou un croisement entre un côté de ladite lame parallèle et un côté de la lame perpendiculaire.

4. Cavité externe (5) selon la revendication 1 ou l'une quelconque des revendications précédentes, dans laquelle la longueur d'une des lames parallèles (110A, 110B) est inférieure afin de permettre une ouverture de faisceau (120) plus large pour recevoir le faisceau incident (70A) et/ou émettre le faisceau rétroréfléchi (70B, 430,440).

5. Cavité externe (5) selon la revendication 1 ou l'une quelconque des revendications précédentes, dans laquelle les trois lames réfléchissantes (110) sont constituées de trois miroirs plans assemblés ou par un dispositif massif, de préférence un étalon ou un guide d'onde plan.

6. Cavité externe (5) selon la revendication 1 ou l'une quelconque des revendications précédentes, dans laquelle la longueur du trajet optique réel à l'intérieur du rétroréflecteur (100) peut être modifiée en faisant varier la longueur des lames parallèles et/ou la longueur de la lame perpendiculaire afin d'accroître le nombre de réflexions à l'intérieur du rétroréflecteur.

7. Cavité externe (5) selon la revendication 1 ou l'une quelconque des revendications précédentes, dans laquelle le trajet optique réel à l'intérieur du rétroréflecteur peut être modifié en faisant varier l'indice de réfraction du matériau du rétroréflecteur.

8. Cavité externe (5) selon la revendication 7, comprenant une unité (150) pour appliquer un effet électro-optique au matériau du rétroréflecteur, de préférence pour appliquer un champ électrique de préférence entre les lames parallèles.

9. Cavité externe (5) selon la revendication 1 ou l'une quelconque des revendications précédentes, comprenant en outre un séparateur de faisceau (410) positionné sur le trajet du faisceau lumineux se propageant dans le rétroréflecteur (400).

10. Cavité externe (5) selon la revendication 9, dans laquelle le séparateur de faisceau (410) est positionné par rapport au faisceau incident (70A) de telle manière qu'un faisceau partiel (410A) transmis à travers le séparateur de faisceau (410) et un faisceau partiel (410B) réfléchi par le séparateur de faisceau (410) se propagent suivant le même trajet, mais dans des sens opposés, à l'intérieur du rétroréflecteur et se rejoignent pratiquement au même point (420) où le faisceau incident (70A) atteint le séparateur de faisceau (410).

11. Cavité externe (5) selon la revendication 9 ou 10, dans laquelle le séparateur de faisceau (410) est positionné pratiquement parallèlement aux lames parallèles (110A et 110B), ou la normale à la surface du séparateur de faisceau (410) est parallèle à la lame perpendiculaire (110C).

12. Cavité externe (5) selon la revendication 9 ou l'une quelconque des revendications 10 et 11, dans laquelle le séparateur de faisceau (410) offre un taux de séparation tel que la part réfléchie est différente de la part transmise, le séparateur de faisceau (410) étant positionné de telle manière que les faisceaux partiels se rejoignant au séparateur de faisceau (410) interfèrent en un premier faisceau de sortie (430) et un second faisceau de sortie (440).

13. Cavité externe (5) selon la revendication 12, dans laquelle le premier faisceau de sortie (430) se propage pratiquement suivant le même trajet que le faisceau incident (70A) mais avec un sens inverse de propagation, et le second faisceau de sortie (440) se propage perpendiculairement au premier faisceau de sortie.

14. Cavité externe (5) selon la revendication 13, dans laquelle le second faisceau de sortie (440) est ensuite redirigé pour quitter le rétroréflecteur parallèlement au premier faisceau de sortie.

15. Cavité externe (5) selon la revendication 9 ou l'une quelconque des revendications 10 et 11, dans laquelle le séparateur de faisceau (410) offre un taux de séparation tel que la part réfléchie est pratiquement la même que la part transmise, le séparateur de faisceau (410) étant positionné de telle manière que les faisceaux partiels se rejoignant au séparateur de faisceau (410) interfèrent en un premier faisceau de sortie (430) se propageant pratiquement suivant le même trajet que le faisceau incident (70A) mais avec un sens inverse de propagation, tandis qu'un second faisceau de sortie (440) perpendiculaire au premier faisceau de sortie est pratiquement annulé par l'interférence destructive.

16. Cavité externe (5) selon la revendication 1, comprenant en outre une unité de contrôle pour modifier la longueur du trajet optique réel du rétroréflecteur (100, 400) pour permettre d'accorder sans saut de mode un faisceau laser dans la cavité (5).

17. Cavité externe (5) selon la revendication 12, dans laquelle le premier faisceau de sortie (430) est rétroréfléchi vers le filtre en longueur d'onde (530) et le second faisceau de sortie (440) est couplé hors de la cavité (5).

18. Cavité externe (5) selon la revendication 17, dans laquelle le second faisceau de sortie (440) est ensuite filtré en longueur d'onde par le filtre en longueur d'onde (530).

19. Cavité externe (5) selon l'une quelconque des revendications 17 et 18, dans laquelle le filtre en longueur d'onde (530) comprend un élément de diffraction.

20. Source laser accordable en longueur d'onde, comprenant
un milieu laser (500) émettant un faisceau laser (30), et
une cavité externe (5) selon l'une quelconque des revendications précédentes, adaptée pour accorder le faisceau laser (30) en longueur d'onde.

21. Procédé pour accorder en longueur d'onde un faisceau laser (30) dans une cavité externe (5) ayant un rétroréflecteur (100) comprenant trois lames réfléchissantes (110), deux (110A, 110B) d'entre elles étant positionnées parallèlement et une (110C) étant positionnée perpendiculairement aux lames parallèles (110A, 110B), de telle manière que le faisceau rétroréfléchi (70B, 430, 440) est parallèle au faisceau incident (70A) mais avec un sens inverse de propagation, comprenant les étapes de :
(a) variation du filtrage en longueur d'onde du faisceau laser (30),
**caractérisé par** le
(b) réglage de la longueur du trajet optique réel à l'intérieur du rétroréflecteur (100) corrélativement du filtrage en longueur d'onde de l'étape (a) afin de permettre d'accorder sans saut de mode le faisceau laser (30)

22. Procédé selon la revendication 21, dans lequel l'étape (b) comprend au moins l'une des étapes de :
variation de la longueur des lames parallèles et/ou de la longueur de la lame perpendiculaire du rétroréflecteur (100) afin d'accroître le nombre de réflexions à l'intérieur du rétroréflecteur, et/ou
variation de l'indice de réfraction du matériau du rétroréflecteur.
